# EUROPEAN PATENT APPLICATION

(11) **EP 4 712 753 A1**
(43) Date of publication of application: **18.03.2026**
(21) Application number: 25196308.8
(22) Date of filing: 18.08.2025
(51) Int. Cl.: H10P 54/00, H10W 72/00, H10W 70/60

(54) **3D SEMICONDUCTOR DEVICE WITH INTERPOSER AND METHOD THEREFOR**

(30) Priority: 12.09.2024 US 202418883000
(71) Applicant: NXP B.V., 5656 AG Eindhoven (NL)
(72) Inventor: Tsai, Yu Ling, 5656AG Eindhoven (NL); Chen, Jian Nian, 5656AG Eindhoven (NL); Huang, Kuan Lin, 5656AG Eindhoven (NL); Chang, Yao Jung, 5656AG Eindhoven (NL)
(74) Representative: Colaiuda, Antonella

(57) **Abstract**

A method of forming a semiconductor device is provided. The method include forming an interposer having a first set of conductive connection pads exposed at a first major side of an interposer substrate and a second set of conductive connection pads exposed at a second major side of the interposer substrate. A first semiconductor wafer is mounted on the first major side of the interposer substrate and a second semiconductor wafer is mounted on the second major side of the interposer substrate. A sandwich-like structure is formed by the first semiconductor wafer, interposer, and second semiconductor wafer. The sandwich-like structure is singulated to form a plurality of individual semiconductor device units. A plurality of sidewall connection pads are exposed along an outer perimeter of the interposer.

## Description

### Background

### Field

This disclosure relates generally to semiconductor device packaging, and more specifically, to three-dimensional (3D) semiconductor devices with an interposer and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified dimensional view, an example semiconductor wafer stack including an interposer at a stage of manufacture in accordance with an embodiment.
FIG. 2 through FIG. 8 illustrate, in simplified cross-sectional views, an example semiconductor device including an interposer at the stages of manufacture in accordance with an embodiment.

### Detailed Description

Generally, there is provided, a 3D semiconductor device having an interposer. The semiconductor device is formed by singulating a sandwich-like structure. The sandwich-like structure includes a first semiconductor wafer and a second semiconductor wafer mounted opposite sides of an interposer panel. Semiconductor die of the first and second semiconductor wafers are interconnected with the interposer panel by way of hybrid bonding. Singulating the sandwich-like structure forms a plurality of semiconductor devices, each having a first semiconductor die and a second semiconductor die mounted opposite sides of an interposer. After singulation, a plurality of sidewall connection pads are exposed around an outer perimeter of the interposer of each semiconductor device. The sidewall connection pads may be interconnected with the first and second semiconductor die by way of the interposer. The semiconductor device may be mounted and interconnected with a printed circuit board by way of the sidewall connection pads. By forming the semiconductor device with the interposer in this manner, a substantially compact 3D semiconductor device may be realized.

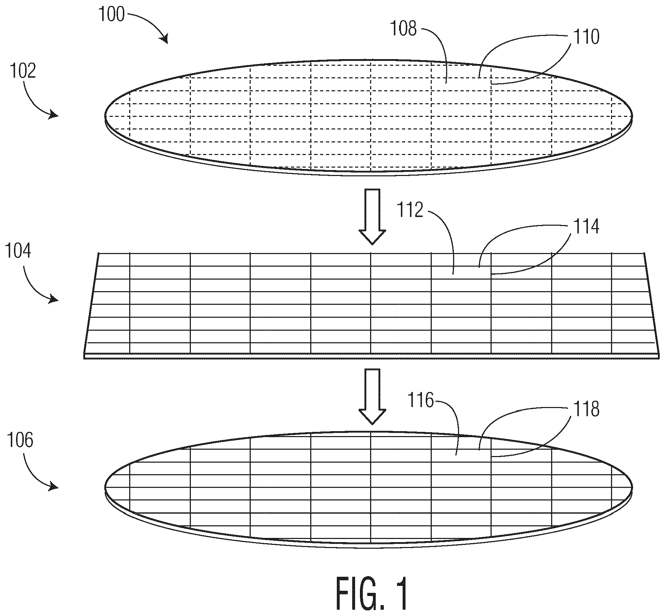

FIG. 1 illustrates, in simplified dimensional view, an example semiconductor wafer stack 100 including an interposer at a stage of manufacture in accordance with an embodiment. At this stage, a first semiconductor wafer 102 and a second semiconductor wafer 106 are positioned at opposite sides of an interposer panel 104. In this embodiment, the first semiconductor wafer 102, the second semiconductor wafer 106, and the interposer 104 are configured to form a sandwich-like structure at subsequent stages of manufacture. The sandwich-like structure includes the semiconductor wafers 102 and 106 arranged in an active-side-to-active-side orientation with the interposer panel 104 disposed between the semiconductor wafers.

The (top) semiconductor wafer 102 is configured in an active-side-down orientation having a plurality of first die sites 108 surrounded by singulation lanes 110 (e.g., scribe streets, saw lanes). Because the backside of the wafer 102 is depicted in FIG. 1, the singulation lanes 110 are shown as dashed lines for illustration purposes. Similarly, the (bottom) semiconductor wafer 106 is configured in an active-side-up orientation having a plurality of second die sites 116 surrounded by singulation lanes 118. The term "die site" as used herein generally refers to an individual semiconductor die while in wafer form. In this embodiment, the die sites of the semiconductor wafers 102 and 106 are configured to have identical sizes and locations. For example, when the semiconductor wafers 102 and 106 are stacked, the singulation lanes 110 and the singulation lanes 118 are aligned forming similar grids of respective die sites 108 and 118.

The semiconductor wafers 102 and 106 have an active side (e.g., major side having circuitry) and a backside (e.g., major side opposite of the active side). The respective die sites (e.g., semiconductor die) 108 and 116 include bond pads (not shown) formed at the active sides, for example. In this embodiment, semiconductor wafer 102 is oriented with the active side down and the semiconductor wafer 106 is oriented with the active side up. Each of the semiconductor wafers 102 and 106 may be formed from any suitable semiconductor material, such as silicon, germanium, gallium arsenide, gallium nitride, and the like. The semiconductor die at respective die sites 108 and 116 may include any digital circuits, analog circuits, RF circuits, power circuits, sensors, memory, processor, the like, and combinations thereof.

The interposer panel 104 is formed in a rectilinear shape in this embodiment. The interposer panel 104 includes a plurality of package sites 112 surrounded by singulation lanes 114. The term "package site" of the interposer panel 104 as used herein generally refers to an individual package interposer while in panel form. In this embodiment, the package sites 112 of the interposer panel 104 are configured to have identical sizes and locations as those of the semiconductor wafers 102 and 106. For example, when the semiconductor wafers 102 and 106 are stacked with the interposer panel 104 in between, the singulation lanes 110, 114 and 118 are aligned.

The interposer panel 104 includes a non-conductive interposer substrate and a plurality of conductive features (not shown) formed in the interposer substrate. The term "conductive," as used herein, generally refers to electrical conductivity unless otherwise described. The interposer panel 104 may be formed from an organic, glass, or silicon material, for example. In this embodiment, the interposer panel 104 is configured for the semiconductor wafer 102 to be mounted at a top major side of the interposer and configured for the semiconductor wafer 106 to be mounted at a bottom major side of the interposer at subsequent stages of manufacture. In this embodiment, portions of the interposer panel 104 extend beyond an outer perimeter of the semiconductor wafers 102 and 106. The singulation lanes 114 in these extended portions of the interposer panel 104 are configured as alignment features for alignment of the semiconductor wafer 102 and the semiconductor wafer 106 to the interposer panel 104. The singulation lanes 114 in the portion of the interposer 104 that extends beyond the outer perimeter of the semiconductor wafers 102 and 106 may be further configured as an alignment guide for a singulation operation at a subsequent stage of manufacture, for example.

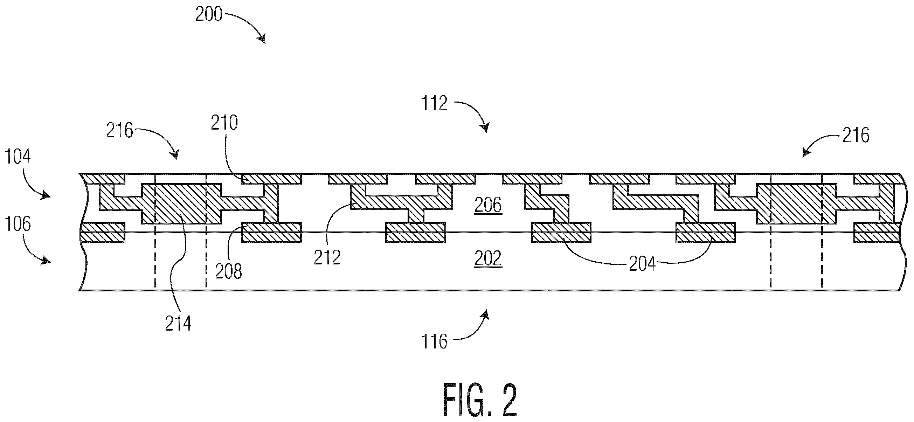

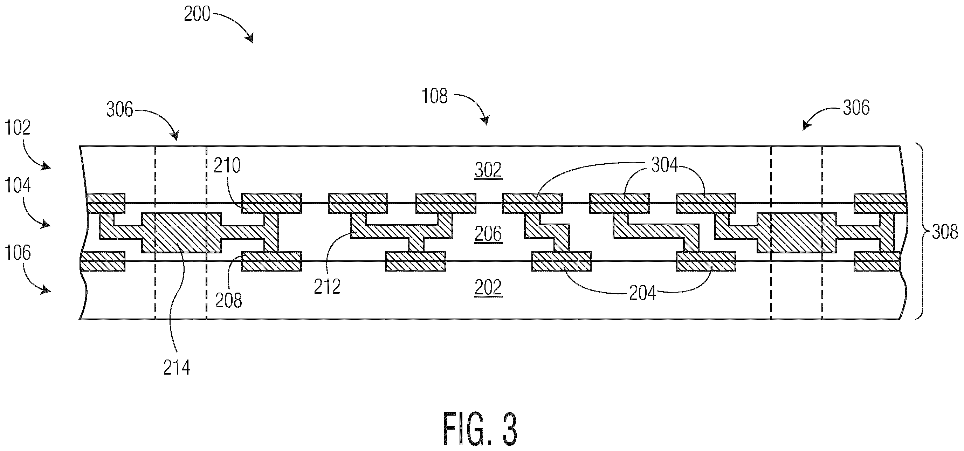

FIG. 2 through FIG. 8 illustrate, in simplified top-side-up cross-sectional views, an example semiconductor device 200 including an interposer at stages of manufacture in accordance with an embodiment. The cross-sectional views depicted in FIG. 2 through FIG. 8 show a package site 112 and die sites 108 and 116 corresponding to the respective package and die sites depicted in FIG. 1. The package site 112 and die sites 108 and 116 are separated from portions of neighboring package sites and die sites by way of singulation lanes 216 and 306 depicted in FIG. 2 and FIG. 3 respectively, for example.

FIG. 2 illustrates, in a simplified cross-sectional view, the example semiconductor device 200 at a stage of manufacture in accordance with an embodiment. At this stage, the semiconductor wafer 106 is mounted on the bottom major side of the interposer panel 104. The interposer panel 104 may also be referred to herein as the interposer 104.

In this embodiment, the interposer 104 includes a non-conductive interposer substrate 206, a first set of conductive (e.g., copper) connection pads 208 exposed at the bottom major side of the interposer substrate, and a second set of conductive (e.g., copper) connection pads 210 exposed at the top major side of the interposer substrate. A plurality of conductive routing structures (e.g., copper traces, vias) of the interposer 104 may be configured for interconnection of the first set of conductive connection pads 208 with the second set of conductive connection pads 208, for example. Conductive bridges 214 are formed in the interposer substrate 206 around an outer perimeter of package site 112. The conductive bridges 214 may extend across the singulation lanes 216 and connect to neighboring package sites, for example. In this embodiment, the conductive bridges 214 are configured to be exposed as sidewall connection pads along sidewalls of the interposer substrate 206 by way of a singulation operation at a subsequent stage of manufacture. The conductive bridges 214 of the interposer 104 may be configured for interconnection with the first set of conductive connection pads 208 and the second set of conductive connection pads 208, for example. In this embodiment, the singulation lanes 216 correspond to a stacked combination of the singulation lanes 114 and 118 of FIG. 1.

The semiconductor wafer 106 includes a semiconductor die 202 and portions of neighboring die as depicted in FIG. 2. The semiconductor die 202 includes bond pads 204 formed at the active side of the semiconductor die. Features such as passivation, interconnecting traces, and circuitry are not shown for illustration purposes. In this embodiment, the bond pads 204 of the semiconductor die 202 are conductively connected to the first set of conductive connection pads 208 of the interposer substrate 206 by way of a hybrid bonding operation. The hybrid bonding operation includes pressing the semiconductor wafer 106 and the interposer 104 together to bond dielectric material surrounding the bond pads 204 and corresponding connection pads 208 followed by a heat treatment to fuse the bond pads 204 and the corresponding connection pads 208.

FIG. 3 illustrates, in a simplified cross-sectional view, the example semiconductor device 200 at a subsequent stage of manufacture in accordance with an embodiment. At this stage, the semiconductor wafer 102 is mounted on the top major side of the interposer 104. In this embodiment, the semiconductor wafer 102 includes a semiconductor die 302 and portions of neighboring die separated by singulation lanes 306 as depicted in FIG. 3. In this embodiment, the singulation lanes 306 correspond to a stacked combination of the singulation lanes 110, 114 and 118 of FIG. 1. The semiconductor die 302 includes bond pads 304 formed at the active side of the semiconductor die. Features such as passivation, interconnecting traces, and circuitry are not shown for illustration purposes. In this embodiment, the bond pads 304 of the semiconductor die 302 are conductively connected to the second set of conductive connection pads 210 of the interposer substrate 206 by way of a second hybrid bonding operation. The second hybrid bonding operation includes pressing the semiconductor wafer 102 and the interposer 104 (with bonded wafer 106) together to bond dielectric material surrounding the bond pads 304 and corresponding connection pads 210 followed by a heat treatment to fuse the bond pads 304 and the corresponding connection pads 210. After the hybrid bonding operation, the sandwich-like structure 308 formed by the semiconductor wafer 102, interposer 104, and semiconductor wafer 106 is completed.

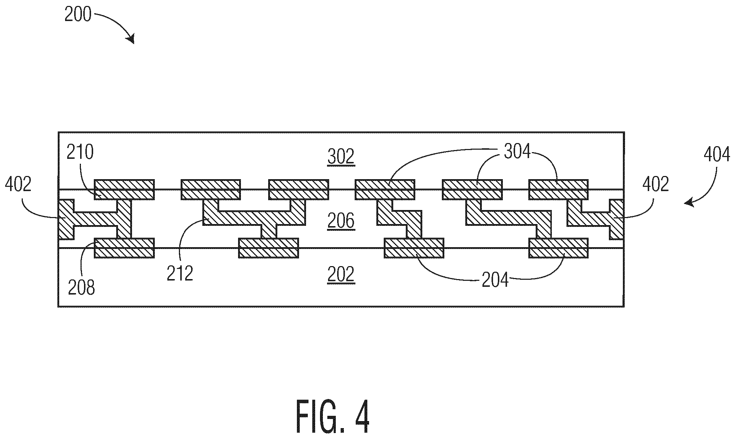

FIG. 4 illustrates, in a simplified cross-sectional view, the example semiconductor device 200 at a subsequent stage of manufacture in accordance with an embodiment. At this stage, the completed sandwich-like structure 308 of FIG. 3 is singulated during a singulation operation to form a plurality of individual semiconductor device units 200. The semiconductor device unit 200 may also be referred to herein as the semiconductor device 200. In this embodiment, a singulation cut is formed along each singulation lane 306 of FIG. 3 to singulate the sandwich-like structure 308 and form the individual semiconductor device 200. In this embodiment, the singulation cut removes portions of the conductive bridges 214 thus exposing sidewall connection pads 402 along outer perimeter sidewalls of the singulated interposer 404. The singulation cut may be formed by a mechanical saw operation or other known methods and techniques.

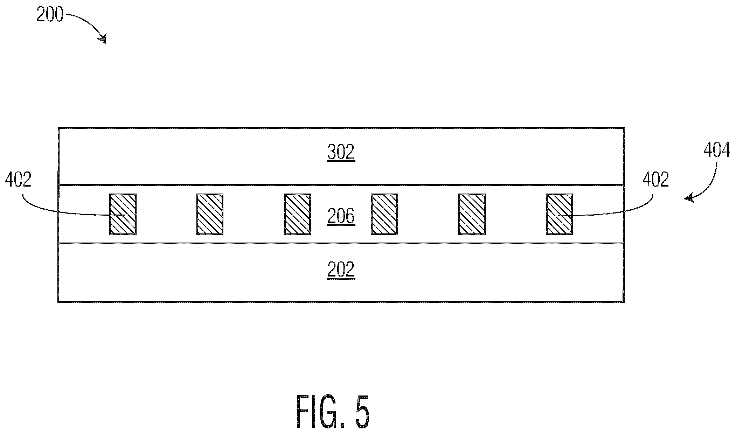

FIG. 5 illustrates, in a simplified side view, the example semiconductor device 200 at the stage of manufacture depicted in FIG. 4 in accordance with an embodiment. As depicted in FIG. 5, the side view shows a singulated sandwich-like structure formed by the semiconductor die 202, interposer 404, and semiconductor die 302. In this embodiment, the sidewall of the interposer substrate 206 of the interposer 404 includes a plurality of exposed sidewall connection pads 402. The sidewall connection pads 402 may be interconnected with the semiconductor die 202 and 302 by way of the conductive routing structures embedded in the interposer substrate 206. In this embodiment, the sidewall connection pads 402 may be characterized as a bare copper or copper alloy material.

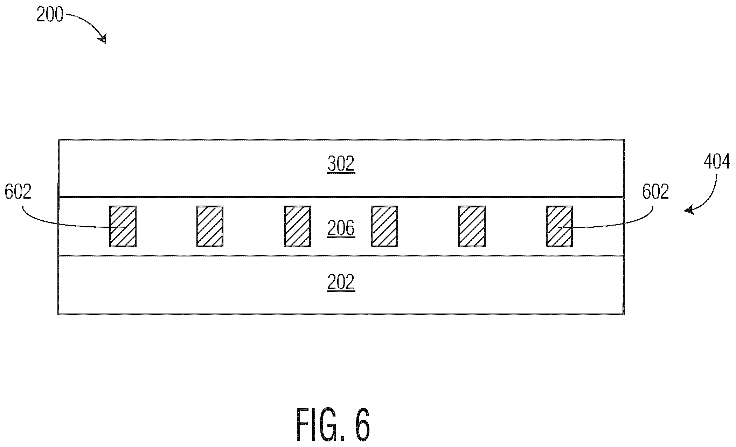

FIG. 6 illustrates, in a simplified side view, the example semiconductor device 200 at the stage of manufacture depicted in FIG. 5 in accordance with an embodiment. As depicted in FIG. 6, the side view shows a singulated sandwich-like structure formed by the semiconductor die 202, interposer 404, and semiconductor die 302. In this embodiment, the sidewall of the interposer substrate 206 of the interposer 404 includes the exposed sidewall connection pads (402 of FIG. 5) treated with a solder enhancement material 602. The solder enhancement material 602 is plated or otherwise applied on the bare copper surface of the sidewall connection pads 402 of FIG. 5, for example. In this embodiment, the solder enhancement material 602 may be characterized as a plated solder or solder alloy coating.

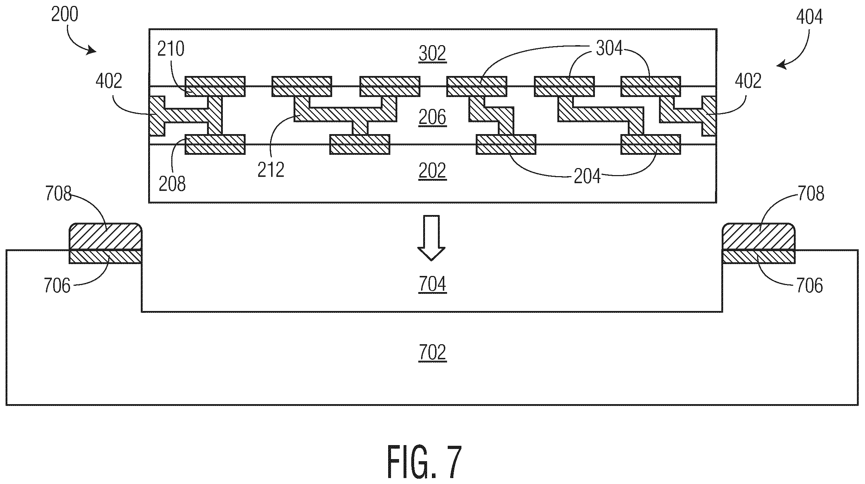

FIG. 7 illustrates, in a simplified cross-sectional view, the example semiconductor device 200 at a subsequent stage of manufacture in accordance with an embodiment. At this stage, the semiconductor device 200 positioned for mounting on a substrate 702. The semiconductor device 200 may be mounted on a package substrate or a printed circuit board (PCB), for example. In this embodiment, the substrate 702 is formed as a PCB having a recess 704 and a plurality of substate pads 706 substantially surrounding the recess. The PCB may be formed from non-conductive FR4 with embedded interconnecting traces and vias (not shown) connected to the substrate pads 706, for example. In this embodiment, solder paste 708 or the like is applied onto the substrate pads 706. The solder paste is configured to form a conductive connection between the sidewall connection pads 402 of the semiconductor device 200 and the substrate pads 706 of the PCB during a reflow operation at a subsequent stage of manufacture, for example.

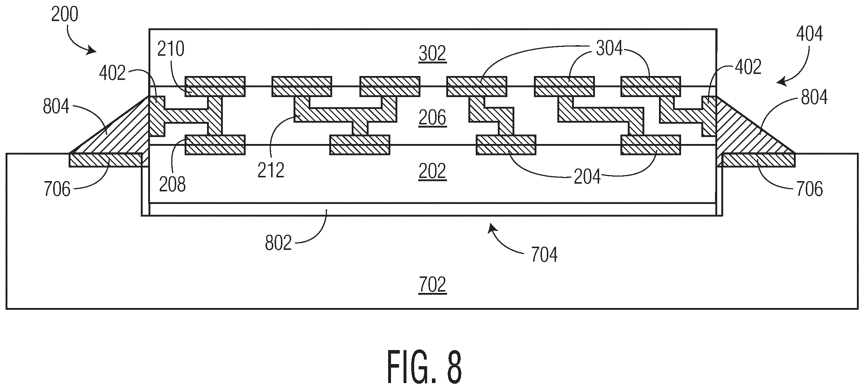

FIG. 8 illustrates, in a simplified cross-sectional view, the example semiconductor device 200 at a subsequent stage of manufacture in accordance with an embodiment. At this stage, the semiconductor device 200 mounted on the substrate 702. In this embodiment, the semiconductor device 200 is affixed on a bottom surface of the recess 704 of the PCB 702 by way of an adhesive 802. The adhesive 802 may be in the form of a die attach film (DAF), for example. After the semiconductor device 200 is mounted in the recess 704 of the PCB 702, a reflow operation is performed. The reflow operation causes the solder paste 708 of FIG. 7 to reflow and form a solder connection 804 interconnecting the sidewall connection pads 402 of the semiconductor device 200 and the substrate pads 706 of the PCB, for example. In this embodiment, the substrate pads 706 of the PCB may be interconnected with the semiconductor die 202 and 302 by way of the interposer 404.

Generally, there is provided, a method including forming an interposer including a first set of conductive connection pads exposed at a first major side of an interposer substrate and a second set of conductive connection pads exposed at a second major side of the interposer substrate, the second major side opposite of the first major side; mounting a first semiconductor wafer on the first major side of the interposer substrate; mounting a second semiconductor wafer on the second major side of the interposer substrate, a sandwich-like structure formed by the first semiconductor wafer, interposer, and second semiconductor wafer; and singulating the sandwich-like structure to form a plurality of individual semiconductor device units, a plurality of sidewall connection pads exposed along an outer perimeter of the interposer. The mounting the first semiconductor wafer on the first major side of the interposer substrate may include mounting an active side of the first semiconductor wafer on the first major side of the interposer substrate and mounting the second semiconductor wafer on the second major side of the interposer substrate may include mounting an active side of the second semiconductor wafer on the second major side of the interposer substrate. The mounting the first semiconductor wafer on the first major side of the interposer substrate may include hybrid bonding first bond pads of the first semiconductor wafer with the first set of conductive connection pads and mounting the second semiconductor wafer on the second major side of the interposer substrate may include hybrid bonding second bond pads of the second semiconductor wafer with the second set of conductive connection pads of the interposer substrate. A portion of the interposer may extend beyond an outer perimeter of the first semiconductor wafer and the second semiconductor wafer, the portion of the interposer configured for alignment of the first semiconductor wafer and the second semiconductor wafer to the interposer substrate. An individual semiconductor device unit may include a first semiconductor die of the first semiconductor wafer interconnected with a second semiconductor die of the second semiconductor wafer by way of the interposer. The exposed sidewall connection pads of the interposer may be interconnected with the first semiconductor die and the second semiconductor die. The method may further include plating the exposed sidewall connection pads of the interposer with a solder material. The exposed sidewall connection pads of the interposer may be configured for interconnection with a printed circuit board (PCB). The interposer substrate may be formed from an organic, glass, or silicon material.

In another embodiment, there is provided, a semiconductor device including an interposer including a first set of conductive connection pads at a first major side of an interposer substrate, a second set of conductive connection pads at a second major side of the interposer substrate, the second major side opposite of the first major side, and a plurality of sidewall pads exposed along an outer perimeter of the interposer substrate; a first semiconductor die mounted on the first major side of the interposer substrate, first bond pads of the first semiconductor die conductively connected to the first set of conductive connection pads; and a second semiconductor die mounted on the second major side of the interposer substrate, second bond pads of the second semiconductor die conductively connected to the second set of conductive connection pads. The sidewall connection pads of the interposer may be interconnected with the first semiconductor die and the second semiconductor die by way of the interposer. The sidewall connection pads of the interposer are configured for interconnection with a printed circuit board (PCB). The first bond pads of the first semiconductor die are hybrid bonded to the first set of conductive connection pads of the interposer and the second bond pads of the second semiconductor die are hybrid bonded to the second set of conductive connection pads of the interposer. The first semiconductor die, the interposer, and the second semiconductor die may be arranged in a stacked die sandwich-like structure having a common outer perimeter. The semiconductor device may further include a solder material plated on the sidewall connection pads of the interposer.

In yet another embodiment, there is provided, a method including forming an interposer including a first set of conductive connection pads exposed at a first major side of an interposer substrate and a second set of conductive connection pads exposed at a second major side of the interposer substrate, the second major side opposite of the first major side; mounting an active side of a first semiconductor wafer on the first major side of the interposer substrate; mounting an active side of a second semiconductor wafer on the second major side of the interposer substrate, a sandwich-like structure formed by a stacked die arrangement of the first semiconductor wafer, interposer, and second semiconductor wafer; and singulating the sandwich-like structure to form a plurality of individual semiconductor device units, a plurality of sidewall connection pads exposed along an outer perimeter of the interposer. The mounting the first semiconductor wafer on the first major side of the interposer substrate may include hybrid bonding first bond pads of the first semiconductor wafer to the first set of conductive connection pads and wherein mounting the second semiconductor wafer on the second major side of the interposer substrate may include hybrid bonding second bond pads of the second semiconductor wafer to the second set of conductive connection pads of the interposer substrate. An individual semiconductor device unit of the plurality of individual semiconductor device units may include a first semiconductor die of the first semiconductor wafer separated from a second semiconductor die of the second semiconductor wafer by way of the interposer. The exposed sidewall connection pads of the interposer may be interconnected with the first semiconductor die and the second semiconductor die. The exposed sidewall connection pads of the interposer may be configured for interconnection with a printed circuit board (PCB).

By now, it should be appreciated that there has been provided a 3D semiconductor device having an interposer. The semiconductor device is formed by singulating a sandwich-like structure. The sandwich-like structure includes a first semiconductor wafer and a second semiconductor wafer mounted opposite sides of an interposer panel. Semiconductor die of the first and second semiconductor wafers are interconnected with the interposer panel by way of hybrid bonding. Singulating the sandwich-like structure forms a plurality of semiconductor devices, each having a first semiconductor die and a second semiconductor die mounted opposite sides of an interposer. After singulation, a plurality of sidewall connection pads are exposed around an outer perimeter of the interposer of each semiconductor device. The sidewall connection pads may be interconnected with the first and second semiconductor die by way of the interposer. The semiconductor device may be mounted and interconnected with a printed circuit board by way of the sidewall connection pads. By forming the semiconductor device with the interposer in this manner, a substantially compact 3D semiconductor device may be realized.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming an interposer including a first set of conductive connection pads exposed at a first major side of an interposer substrate and a second set of conductive connection pads exposed at a second major side of the interposer substrate, the second major side opposite of the first major side;
mounting a first semiconductor wafer on the first major side of the interposer substrate;
mounting a second semiconductor wafer on the second major side of the interposer substrate, a sandwich-like structure formed by the first semiconductor wafer, interposer, and second semiconductor wafer; and
singulating the sandwich-like structure to form a plurality of individual semiconductor device units, a plurality of sidewall connection pads exposed along an outer perimeter of the interposer.

2. The method of claim 1, wherein:
mounting the first semiconductor wafer on the first major side of the interposer substrate includes mounting an active side of the first semiconductor wafer on the first major side of the interposer substrate; and
mounting the second semiconductor wafer on the second major side of the interposer substrate includes mounting an active side of the second semiconductor wafer on the second major side of the interposer substrate.

3. The method of claim 1 or claim 2, wherein:
mounting the first semiconductor wafer on the first major side of the interposer substrate includes hybrid bonding first bond pads of the first semiconductor wafer with the first set of conductive connection pads; and
mounting the second semiconductor wafer on the second major side of the interposer substrate includes hybrid bonding second bond pads of the second semiconductor wafer with the second set of conductive connection pads of the interposer substrate.

4. The method of claim 1, wherein a portion of the interposer extends beyond an outer perimeter of the first semiconductor wafer and the second semiconductor wafer, the portion of the interposer configured for alignment of the first semiconductor wafer and the second semiconductor wafer to the interposer substrate.

5. The method according to any preceding claim, wherein an individual semiconductor device unit includes a first semiconductor die of the first semiconductor wafer interconnected with a second semiconductor die of the second semiconductor wafer by way of the interposer.

6. The method of claim 5, wherein the exposed sidewall connection pads of the interposer are interconnected with the first semiconductor die and the second semiconductor die.

7. The method according to any preceding claim, further comprising plating the exposed sidewall connection pads of the interposer with a solder material.

8. The method according to any preceding claim, wherein the exposed sidewall connection pads of the interposer are configured for interconnection with a printed circuit board (PCB).

9. The method according to any preceding claim, wherein the interposer substrate is formed from an organic, glass, or silicon material.

10. A semiconductor device comprising:
an interposer including:
a first set of conductive connection pads at a first major side of an interposer substrate,
a second set of conductive connection pads at a second major side of the interposer substrate, the second major side opposite of the first major side, and
a plurality of sidewall pads exposed along an outer perimeter of the interposer substrate;
a first semiconductor die mounted on the first major side of the interposer substrate, first bond pads of the first semiconductor die conductively connected to the first set of conductive connection pads; and
a second semiconductor die mounted on the second major side of the interposer substrate, second bond pads of the second semiconductor die conductively connected to the second set of conductive connection pads.

11. The semiconductor device of claim 10, wherein the sidewall connection pads of the interposer are interconnected with the first semiconductor die and the second semiconductor die by way of the interposer.

12. The semiconductor device of claim 10 or claim 11, wherein the sidewall connection pads of the interposer are configured for interconnection with a printed circuit board (PCB).

13. The semiconductor device according to any of claims 10 to 12, wherein:
the first bond pads of the first semiconductor die are hybrid bonded to the first set of conductive connection pads of the interposer; and
the second bond pads of the second semiconductor die are hybrid bonded to the second set of conductive connection pads of the interposer.

14. The semiconductor device according to any of claims 10 to 13, wherein the first semiconductor die, the interposer, and the second semiconductor die are arranged in a stacked die sandwich-like structure having a common outer perimeter.

15. The semiconductor device according to any of claims 10 to 14further comprising a solder material plated on the sidewall connection pads of the interposer.
